# EUROPÄISCHE PATENTSCHRIFT

(11) **EP 2 859 587 B1**
(45) Veröffentlichungstag und Bekanntmachung des Hinweises auf die Patenterteilung: **09.08.2017**
(21) Anmeldenummer: 13742502.1
(22) Anmeldetag: 05.06.2013
(51) Int. Cl.: H01L 27/30, H01L 51/42, H02S 40/20, H01L 51/44

(54) **FILTERSYSTEM FÜR PHOTOAKTIVE BAUELEMENTE**
FILTER SYSTEMS FOR PHOTOACTIVE DEVICES
SYSTÈMES DE FILTRES POUR DES DISPOSITIFS PHOTOACTIVES

(30) Priorität: 11.06.2012 DE 102012105013
(43) Veröffentlichungstag der Anmeldung: 15.04.2015
(73) Patentinhaber: Heliatek GmbH, 01139 Dresden (DE)
(72) Erfinder: WALZER, Karsten, 01099 Dresden (DE); MAENNIG, Bert, 01127 Dresden (DE)
(86) Internationale Anmeldenummer: PCT/IB2013/054625
(87) Internationale Veröffentlichungsnummer: WO 2013/186668

(56) Entgegenhaltungen:
- WO-A1-2011/052565
- WO-A2-2009/024509
- WO-A2-2010/126699
- JP-A- 2010 135 334
- HUI JOON PARK ET AL: "Photonic Color Filters Integrated with Organic Solar Cells for Energy Harvesting", ACS NANO, Bd. 5, Nr. 9, 27. September 2011 (2011-09-27), Seiten 7055-7060, XP55075653, ISSN: 1936-0851, DOI: 10.1021/nn201767e

## Beschreibung

Die Erfindung betrifft ein Filtersystem für photoaktive Bauelemente.

Photoaktive Bauelemente, wie etwa Solarzellen finden heute eine breite Anwendung im alltäglichen sowie industriellen Umfeld. Von besonderem Interesse ist dabei die Integration von photovoltaischen Elementen in Gebäuden (gebäudeintegrierte Photovoltaik - GiPV, häufig auch BiPV von englisch Buildingintegrated Photovoltaic genannt) oder in Fahrzeugen (AiPV), wobei nicht nur die klassische Energiegewinnung (Umwandlung von Sonnenlicht in Strom) sondern auch weitere Funktionen gewünscht werden. Die Fachgruppe "Photovoltaik in Gebäuden" unter dem Dach des Bundesverbandes für Bausysteme e. V. beschreibt BiPV als eine architektonische, bauphysikalische und konstruktive Einbindung von PV-Elementen in die Gebäudehülle unter Berücksichtigung der multifunktionalen Eigenschaften des PV-Moduls.

Insbesondere die Integration photoaktiver Bauelemente in Glaselemente ist von besonderem Interesse, wobei dies nicht nur für den BiPV Bereich sondern auch für andere Bereiche, wie etwa Automotive gilt.

Die Integration in Glasfassaden stellt jedoch gewisse Schwierigkeiten dar, da oft ein farbneutraler Eindruck gewünscht ist. Dies ist jedoch insbesondere bei farbigen Absorbersystemen schwer realisierbar.

Daneben besteht auch das Bedürfnis die Transmission nur bestimmter Wellenlängenbereiche durch das photoaktive Bauelement zuzulassen. Dadurch können beispielsweise bestimmte Wellenlängenbereiche selektiv das photoaktive Bauelement passieren, was beispielsweise im Pflanzenzuchtbereich, etwas beim Einsatz in Gewächshäusern, erwünscht ist.

Spezielle Einsatzbereiche von Solarzellen erfordern ggf. eine Anpassung der visuellen Erscheinung, insbesondere des Farbeindrucks.

Dies kann gewünscht sein sowohl für opake als auch für semitransparente Solarzellen.

Dabei können verschiedene Ziele gesetzt sein, so z.B. das Erreichen von bestimmter Objektfarbe oder das Erreichen einer bestimmten Farbe für transmittiertes Licht.

Die Objektfarbe ist z.B. relevant bei Design- oder BIPV-Anwendungen, in denen der Kunde die Farbe seines Produktes oder seiner Gebäudehülle wählen möchte, oder bei getönten KFZ-Scheiben, wo je nach Hersteller eine andere Farbnuance gewünscht ist.

Die Farbe transmittierten Lichtes kann z.B. dann relevant sein, wenn Farbneutralität des transmittierten Lichtes erreicht werden soll, d.h. wenn die zu durchscheinende Solarzelle im Wesentlichen als Graufilter zur Reduktion des Lichteinfalls wirken soll. Dies kann z.B. bei BIPV-Lösungen der Fall sein, bei denen im Innenraum eines Gebäudes spektral gesehen Tageslichtverhältnisse herrschen sollen.

Ein ähnlicher Anwendungsfall ergibt sich in Kraftfahrzeug bei denen je nach Hersteller und Einsatzzweck verschieden getönte Fahrzeugscheiben mit semitransparenter Photovoltaik versehen, eingesetzt werden sollen.

Bisherige Lösungen sind durch die Verwendung von Solarmodulen auf Silizium-Basis gekennzeichnet, welche zumeist in Plattenform ausgebildet sind. Die Anordnung an Bauwerksoberflächen erfolgt dabei zumeist über Ständersysteme auf Dächern bzw. Vorhangsystemen an Wänden. Solche Systeme sind insbesondere durch ihren konstruktiv aufwändigen Aufbau und durch das insgesamt hohe Gewicht gekennzeichnet. Die Konstruktionen zur Aufnahme entsprechender plattenförmiger Module müssen zudem eine hinreichende Sicherung der Module gegen Herunterfallen bieten, da die plattenförmigen Module aufgrund des Eigengewichts andernfalls entsprechende Risiken für Personen und Objekte darstellen.

Problematisch ist zudem, dass siliziumbasierte Module für eine optimale Effizienz eine Ausrichtung nach Süden und gegebenenfalls einen Aufstellwinkel von 30° benötigen, um eine optimale Sonneneinstrahlung zu gewährleisten.

Hinzu kommt, dass siliziumbasierte photovoltaische Module durch infolge direkter Sonnenbestrahlung sich ausbildende erhöhte Temperatur in den Modulen Leistungsverluste aufweisen. Daher ist es vorteilhaft entsprechende Systeme mit aktiver oder passiver Hinterlüftung einzusetzen.

Eine direkte Anordnung siliziumbasierter Zellen auf Bauwerksoberflächen ist vor dem Hintergrund der oben beschriebenen Ausrichtung nach Süden, des notwendigen Aufstellwinkels, Absturzsicherung und der Hintergrundlüftung schwierig.

Alternative Systeme stellen beispielsweise direkt in Dachziegel integrierte photovoltaische Elemente bereit.

Besondere Herausforderungen stellen bisher gewölbte oder gekrümmte Bauwerksoberflächen, etwa bei Glasfassaden, dar. Entsprechende Geometrien sind dabei bei Verwendung von siliziumbasierten plattenförmigen Modulen nur schwer realisierbar.

Als Alternative zu plattenförmigen Modulen bieten sich etwa Dünnschichtsolarzellen mit flexibler Ausgestaltung an.

So sind beispielsweise Dünnschicht-Solarzellen bekannt, welche eine flexible Ausgestaltung aufweisen und damit eine Anordnung auf gekrümmten Oberflächen erlauben. Solche Solarzellen weisen dabei bevorzugt aktive Schichten aus amorphen oder nicht kristallinen Silicium (α-Si, µ-Si), CdTe oder CIGS (Cu (In, Ga) (S, Se)₂) auf.

Nachteilig bei diesen Dünnschicht-Solarzellen sind die vor allem durch die Materialien bedingten hohen Produktionskosten.

Weiterhin bekannt sind auch Solarzellen mit organischen aktiven Schichten, welche flexibel ausgestaltet sind (Konarka - Power Plastic Series). Die organischen aktiven Schichten können dabei aus Polymeren (z.B. US7825326 B2) oder kleinen Molekülen (z.B. EP 2385556 A1) aufgebaut sein. Während Polymere sich dadurch auszeichnen, dass diese nicht verdampfbar und daher nur aus Lösungen aufgebracht werden können, sind kleine Moleküle verdampfbar.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm-1), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie. Ein weiterer Vorteil liegt in der Möglichkeit, transparente Bauelemente herstellen zu können, welche beispielsweise in Glasapplikationen eingesetzt werden können. Ein weiterer wesentlicher Vorteil sind die geringeren Kosten gegenüber anorganischen Halbleiterbauelementen.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht (en),
3. i- Schicht (en),
4. n- Schicht (en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulkheterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich < 450 nm liegt, vorzugsweise bei < 400 nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei organische Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Bekannt sind Systeme zur Integration von Solarzellen in Gebäuden, wobei auch flexible Solarzellen verwendet werden. So offenbart die JP 2011-109051A die Anordnung einer amorphen Solarzelle auf einem Kunststoffplatte, welches anschließend an Gebäuden angebracht werden kann. Aufgrund der Ausgestaltung ist jedoch keine hinreichende Flexibilität des so gestalteten Moduls zu erwarten, welche eine Anordnung auf gekrümmten und gewölbten Oberflächen erfordern würde.

Die EP 1191605 A2 beschriebt ein glasloses, flexibles Solarlaminat für die Verwendung in der Gebäudetechnik, wobei die Solarzellen unter Druck und Temperatur (ca. 130°C) auf ein Stahlblech aufgebracht werden und diese anschließend durch eine rückseitig angeordnete Klebschicht auf Gebäude-Außenflächen angebracht.

Die WO20120303971 beschreibt ein flexibles Dünnschichtsolarzellenmodul auf CIGS-Basis (Copper indium gallium diselenide)mit mehreren Lagen an Dünnschichtsolarzellen, welche mittels Lamination zusammengefügt wurden. Das Modul weist an seiner Rückseite eine Klebeschicht zur Anordnung an Gebäudeaußenflächen auf.

WO 2009024509 A2 schlägt vor eine transparente Solarzelle mit mindestens eine mit einem oder einer Mischung mehrerer Fluoreszenzfarbstoffe dotierten Polymerschicht zu überziehen, um die Effizienz mit Hilfe der zusätzlichen als Reflektor dienenden Spiegelfläche zu verbessern.

H.J. Park u. a.: ACS NANO 5 (2011) 7055-7060 verwendet Au Nanogratings als Gegenelektrode einer Polymersolarzelle, die durch die Wahl der Dicke der photoaktiven Polymerschicht und des Abstandes der Nanogratings den optischen Farbeindruck der Solarzelle verändern kann.

WO 2010126699 A2 offenbart eine Weiterverarbeitung bestehender, bestehender Polymer-Solarzellen mit Hilfe einer vorgeformten Substrats.

JP 2010135334 A offenbart eine Uhr mit mehreren Farbfiltern nebeneinander und nicht übereinander.

Das Familienmitglied US 2012204961 A1 der WO 2011052565 A1 zeigt eine Solarzelle mit genau zwei UV absorbierenden Schicht, um die Degradierung der Solarzelle zu vermindern.

Der Bedarf an zunehmender Integration von Solarmodulen in Gebäuden und Bauwerken auch mit komplexer Geometrie erfordert neue Konzepte der Gestaltung der Solarmodule sowie der Anordnung der Solarmodule an Formteilen.

Die Aufgabe der vorliegenden Erfindung besteht daher darin ein Solarmodul anzugeben, welches die Nachteile des Stands der Technik überwindet.

Die Aufgabe wird durch ein Bauelement gemäß dem Hauptanspruch gelöst. Vorteilhafte Ausgestaltungen sind in den abhängigen Ansprüchen angegeben.

Erfindungsgemäß wird ein photoaktives Bauelement auf einem Substrat vorgeschlagen, umfassend eine erste und eine zweite Elektrode, wobei die erste Elektrode auf dem Substrat angeordnet ist und die zweite Elektrode eine Gegenelektrode bildet, wobei zwischen diesen Elektroden zumindest ein photoaktives Schichtsystem angeordnet ist. Erfindungsgemäß umfasst das photoaktive Bauelement weiterhin zumindest eine Schicht oder Schichtfolge, welche so ausgestaltet ist, dass diese in dem photoaktiven Bauelement als spektral selektiver Farbfilter im VIS-Bereich wirkt. Spektral selektiver Farbfilter bedeutet hierbei, dass die als Farbfilter wirkende Schicht oder Schichtfolge in einem bestimmten Wellenlängenbereich des sichtbaren Spektrums im Bereich von 450 nm bis 800 nm absorbiert, wobei der Farbfilter entsprechend den Anwendungserfordernissen ausgewählt wird. Durch die Auswahl des spektral selektiven Farbfilters kann sowohl die Transmission als auch die Reflektion des photoaktiven Bauelements eingestellt werden.

In einer weiteren Ausführungsform der Erfindung umfasst das photoaktive Bauelement weiterhin zumindest eine Schicht oder Schichtfolge, welche so ausgestaltet ist, dass diese in dem photoaktiven Bauelement als spektral selektiver IR-Filter im IR-Bereich wirkt. Spektral selektiver IR-Filter bedeutet hierbei, dass die als IR-Filter wirkende Schicht oder Schichtfolge in einem bestimmten Wellenlängenbereich des IR-Spektrums im Bereich von 1100 nm bis 2500 nm absorbiert, wobei der IR-Filter entsprechend den Anwendungserfordernissen ausgewählt wird. Durch den zusätzlichen IR-Filter wird der Eintrag thermischer Energie, beispielsweise in Gebäude verringert. Dadurch kann eine starke Erwärmung in Gebäuden oder Gewächshäusern vermieden werden. Ebenso wird damit eine zu starke Erwärmung der Solarzelle verhindert, welche bei Solarzellen mit negativem Temperaturkoeffizient zur Verringerung des Ertrags bei Erhöhung der Temperatur führt.

In einer weiteren Ausführungsform der Erfindung umfasst das photoaktive Bauelement weiterhin zumindest eine Schicht oder Schichtfolge, welche so ausgestaltet ist, dass diese in dem photoaktiven Bauelement als spektral selektiver UV-Filter im UV-Bereich von 250 nm bis 430 nm wirkt. Durch den zusätzlichen UV-Filter werden beispielsweise die im photoaktiven Bauelement enthaltenen organischen Moleküle vor einer möglichen Degradierung geschützt. Gleiches gilt für möglicherweise eingesetzte Polymere, Kleb- sowie Laminierstoffe.

In einer ersten Ausführungsform umfasst die als Farbfilter wirkende Schicht oder Schichtfolge zumindest ein absorbierendes Material, wobei die Schicht so ausgestaltet ist, dass diese keine elektrische Kontaktierung aufweist.

In einer weiteren Ausführungsform der Erfindung ist die als Farbfilter wirkende Schicht oder Schichtfolge außerhalb des elektrisch aktiven Teils des photoaktiven Bauelements, d.h. außerhalb der Elektroden, angeordnet.

In einer weiteren Ausführungsform der Erfindung umfasst die als Farbfilter wirkende Schicht oder Schichtfolge organische und/oder anorganische Stoffe oder einer Kombination davon. Bevorzugt werden organische Farbstoffe verwendet. Diese organischen Farbstoffe haben eine spektrale Halbwertsbreite typischerweise zwischen 50 nm und 300 nm und sind aufgrund dieser Selektivität besonders zur selektiven Filterung im sichtbaren Bereich geeignet.

In einer weiteren Ausführungsform der Erfindung umfasst die als Farbfilter wirkende Schicht oder Schichtfolge Nanomaterialien, wie etwa Nanokristalle, Nanodrähten, Nanopartikel, welche als farblich selektiv absorbierende Schicht ausgebildet sind.

In einer weiteren Ausführungsform der Erfindung ist die als Farbfilter wirkende Schicht oder Schichtfolge entweder auf der der Lichteinstrahlung zugewandten oder auf der der Lichteinstrahlung abgewandten Seite des photoaktiven Bauelements angeordnet.

In einer Ausgestaltung dieser Ausführungsform ist die als Farbfilter wirkende Schicht oder Schichtfolge auf der der Lichteinstrahlung zugewandten Seite des photoaktiven Bauelements angeordnet, wobei die Schicht oder Schichtfolge so ausgestaltet ist, dass sie den für die Wirkung des photoaktiven Bauelements relevanten Teil des Spektrums durchlässt.

In einer weiteren Ausführungsform der Erfindung umfasst die als Farbfilter wirkende Schicht oder Schichtfolge zumindest einen Fluoreszenzfarbstoff. Dieser Fluoreszenzfarbstoff kann so gewählt sein, dass dieser Licht aus einem ausgewählten Spektralbereich absorbiert und in einem gewünschten Spektralbereich emittiert. Dadurch kann beispielsweise der farbliche Eindruck angepasst werden. Aufgrund der Emission durch den Fluoreszenzfarbstoff kann es dabei zu einer Reabsorption im photoaktiven Schichtsystem des photoaktiven Bauelements kommen und somit zu einer Effizienzsteigerung. Bei einer entsprechenden Auswahl des Fluoreszenzsemitters entsprechend den Anwenderanforderungen können farbig gestaltete Oberflächen ausgebildet werden. Dies ist beispielsweise von Interesse für Werbeanwendungen.

In einer Ausführungsform der Erfindung ist die als Farbfilter wirkende Schicht oder Schichtfolge auf der lichtzugewandten Seite des photoaktiven Bauelements als metallische Struktur, wie etwa Metallschicht, Metallgitter, etc. ausgeführt. Vorteilhafterweise weist die metallische Struktur eine Schichtdicke zwischen 1 bis 10 nm auf.

In einer Ausgestaltung der Ausführungsform ist die als Farbfilter wirkende Schicht oder Schichtfolge auf der der Lichteinstrahlung abgewandten Seite des photoaktiven Bauelements angeordnet. Vorteilhaft ist diese Lösung immer dann, wenn die als Farbfilter wirkende Schicht oder Schichtfolge kein Licht absorbiert, welches auch von der photoaktiven Schicht des photoaktiven Bauelements genutzt werden kann. Dies erreicht man verlustfrei dadurch, dass die als Farbfilter wirkende Schicht oder Schichtfolge einen zusätzlichen Absorber umfasst, welcher auf der der Lichteinstrahlung abgewandten Seite aufgebracht ist, oder durch Wahl eines selektiven Absorbers, der in unerwünschten Spektralbereichen das eintretende Licht herausfiltert und z.B. als UV-Filter wirken kann. So ausgestaltete Bauelemente lassen sich beispielsweise besonders vorteilhaft dort einsetzen, wo nur bestimmte Wellenlängenbereiche das photoaktive Bauelement passieren sollen. Dies ist beispielsweise bei Integration in Glas oder Applikation der Bauelemente auf Folien denkbar. Besonders geeignet sind so ausgestaltete Bauelemente beispielsweise zur Anordnung auf Gewächshäusern. Dabei kann beispielsweise eine Filterung dahingehend realisiert werden, dass Strahlung im Infrarot-Bereich nicht passieren kann, wodurch eine Erwärmung innerhalb des Gewächshauses vermieden werden kann. Dies wird beispielsweise durch mehrere Schichten aus Metall oder Metalloxid realisiert. Gleichzeitig ist die als Farbfilter wirkende Schicht so ausgestaltet, dass die für die Pflanzen notwendigen Spektralbereiche passieren können. Dadurch kann neben der Stromgenerierung durch das photoaktive Bauelement auch hinreichend Licht passieren, um ein optimales Wachstum der Pflanzen zu gewährleisten. Der durch das photoaktive Bauelement generierte Strom kann dabei beispielsweise genutzt werden, um eine zusätzliche Beleuchtung oder Belüftung zu betreiben, welche bei abnehmender Lichtmenge eingesetzt wird, um die Beleuchtungsphase zu verlängern oder Beregnungssysteme zu betreiben. Durch die sich ergebende Infrarot-Filterung wird zudem eine Aufheizung innerhalb des Gewächshauses vermieden. Vorteilhaft ist auch die Ausgestaltung dahingehend, dass das photoaktive Bauelement auf einem transparenten oder opaken flexiblen Substrat angeordnet ist, wodurch das Gewächshaus direkt aus den auf dem Substrat angeordneten Bauelementen errichtet werden kann. Dadurch können Gewächshäuser in Leichtbauform entstehen.

In einer weiteren Ausführungsform der Erfindung ist die als Farbfilter wirkende Schicht oder Schichtfolge als im Vakuum oder aus Lösung aufgebrachte Dünnschicht ausgebildet.
In einer Ausgestaltung der vorbeschriebenen Ausführungsform ist weist die Schicht oder Schichtfolge eine Schichtdicke von zumindest 3nm bis 100 µm, bevorzugt zwischen 5 nm und 300 nm auf.

In einer weiteren Ausführungsform der Erfindung umfasst die als Farbfilter wirkende Schicht oder Schichtfolge mindestens einen Absorber. In einer Ausgestaltung der vorbeschriebenen Ausführungsform umfasst die als Farbfilter wirkende Schicht oder Schichtfolge eine Mischung und/oder Abfolge zweier oder mehrerer Absorber. Der Fall dass mehr als ein zusätzlicher Absorber verwendet wird hat den Vorteil, dass damit eine weitere spektrale Verbreiterung möglich wird, die z.B. zum Erreichen von Farbneutralität vorteilhaft ist.

In einer weiteren Ausführungsform der Erfindung ist die als Farbfilter wirkende Schicht oder Schichtfolge als eine mit organischen oder anorganischen Farbstoffen gefärbte Folie ausgebildet. In einer Ausgestaltung dieser Ausführungsform weist die Folie eine Dicke von mindestens 3 µm bis 1000 µm, bevorzugt 10 µm bis 300 µm auf.

In einer weiteren Ausführungsform der Erfindung ist die als Farbfilter wirkende Schicht oder Schichtfolge als ein mit organischen oder anorganischen Farbstoffen gefärbtes Glas, mit einer Dicke von mindestens 50 µm, ausgebildet.

In einer alternativen Ausführungsform der Erfindung ist die als Farbfilter wirkende Schicht oder Schichtfolge als eine Ladungsträgertransportschicht ausgeführt, welche eine Absorption in zumindest einem Teilbereich des Wellenlängenbereichs aufweist. Dabei fungiert die zumindest eine Ladungsträgertransportschicht als Farbfilter. Die Ladungsträgertransportschicht umfasst dabei zumindest einen Lochleiter (HTL) und/oder Elektronenleitermaterial (ETL), welches so gewählt wird, dass diese eine selektive Absorption im gewünschten Wellenlängenbereich haben und so die Farberscheinung einstellen.

Dies kann entweder dadurch erfolgen, dass die ETL/HTL-Materialien selbst farbig sind, oder sie eine Beimischung enthalten, die farbig selektiv absorbiert. Das in diesen Ladungsträgertransportschichten absorbierte Licht trägt dabei nicht zur Generation von Ladungsträgern bei, was diese Ladungsträgertransportschicht von den Absorbern in der photoaktiven Schicht unterscheidet.
Durch die gezielte Auswahl der Materialien für die Ladungsträgertransportschichten kann so ein im photoaktiven Bauelement integrierter Farbfilter realisiert werden, ohne dass eine zusätzliche Schicht außerhalb der Elektroden angeordnet werden müsste.

In einer weiteren Ausführungsform der Erfindung wird die als Farbfilter wirkende Schicht oder Schichtfolge dazu verwendet, um Inhomogenitäten im Farbeindruck auszugleichen. Dies kann beispielsweise bei produktionsbedingten unterschiedlichen Schichtdicken der Fall sein, wo etwa im Randbereich eine geringere Abscheidung der Schichten des photoaktiven Bauelements erfolgt.

In einer weiteren Ausführungsform der Erfindung weist die als Farbfilter wirkende Schicht oder Schichtfolge eine Strukturierung auf. Dadurch werden bewusst Inhomogenitäten im Farbeindruck des photoaktiven Bauelements generiert, was zur Wahrnehmung eines Musters führt. Dadurch können beispielsweise Logos etc. realisiert werden, um eine Individualisierung des Bauelements gemäß den Anforderungen des Anwenders zu realisieren.

In einer Ausführungsform der Erfindung ist das Substrat opak oder transparent ausgeführt.

In einer Ausführungsform der Erfindung weist die als Farbfilter wirkende Schicht oder Schichtfolge eine Schichtdicke zwischen 5 und 500 nm auf, wodurch über dünnschichtoptische Effekte eine Anpassung der Filterwirkung erzielt wird.

In einer Ausführungsform der Erfindung ist das Substrat als Glas oder Folie ausgeführt.

In einer Ausführungsform der Erfindung wird im photoaktiven Bauelement zumindest eine organische Schicht aus mindestens einem organischen Material verwendet, welche zwischen der Elektrode und der Gegenelektrode angeordnet ist.

In einer Ausführungsform der Erfindung ist die organische Schicht als aktive Schicht im photoaktiven Bauelement ausgebildet.

In einer weiteren Ausführungsform der Erfindung weist die aktive Schicht zumindest ein organisches Material auf.

In einer weiteren Ausführungsform der Erfindung umfasst die aktive Schicht mindestens eine Mischschicht mit mindestens zwei Hauptmaterialien, wobei diese ein aktives Donor-Akzeptor-System bilden.

In einer weiteren Ausführungsform der Erfindung ist zumindest ein Hauptmaterial ein organisches Material.

In einer weiteren Ausführungsform der Erfindung handelt es sich bei dem organischen Material um kleine Moleküle. Unter dem Begriff kleine Moleküle werden im Sinne der Erfindung Monomere verstanden, die im Vakuum verdampft und damit auf dem Substrat abgeschieden werden können.

In einer weiteren Ausführungsform der Erfindung handelt es sich bei dem organischen Material zumindest teilweise um Polymere. Dabei wird aber zumindest eine photoaktive i-Schicht aus kleinen Molekülen gebildet.

In einer weiteren Ausführungsform der Erfindung umfasst mindestens eine der aktiven Mischschichten als Akzeptor ein Material aus der Gruppe der Fullerene bzw. Fullerenderivate.

In einer weiteren Ausführungsform der Erfindung ist zwischen der Elektrode und der Gegenelektrode zumindest eine dotierte, teilweise dotierte oder undotierte Transportschicht angeordnet.

In einer weiteren Ausführungsform der Erfindung ist das Bauelement zumindest in einem gewissen Lichtwellenlängenbereich zwischen 200 nm und 3 µm semitransparent.

In einer weiteren Ausführungsform der Erfindung ist das photoaktive Bauelement eine organische Solarzelle.

In einer weiteren Ausführungsform der Erfindung handelt es sich bei dem Bauelement um eine pin-Einzel, pin-Tandemzelle, pin-Mehrfachzelle, nip-Einzelzelle, nip- Tandemzelle oder nip-Mehrfachzelle.

In einer weiteren Ausführungsform der Erfindung besteht das Bauelement aus einer Kombination aus nip, ni, ip, pnip, pni, pip, nipn, nin, ipn, pnipn, pnin oder pipn-Strukturen, bei der mehrere unabhängige Kombinationen, die mindestens eine i-Schicht enthalten, übereinander gestapelt sind.

In einer weiteren Ausführungsform der Erfindung weist das photoaktive Bauelement zwischen der Elektrode und der Gegenelektrode mehr als eine photoaktive Schicht auf.

In einer weiteren Ausführungsform der Erfindung besteht das aktive Schichtsystem des photoaktiven Bauelementes mindestens aus zwei Mischschichten, die direkt aneinandergrenzen und mindestens eine der beiden Hauptmaterialien einer Mischschicht ein anderes organisches Material ist als die beiden Hauptmaterialien einer anderen Mischschicht. Jede Mischschicht besteht aus mindestens zwei Hauptmaterialien, wobei diese ein photoaktives Donor-Akzeptor-System bilden. Das Donor-Akzeptor-System zeichnet sich dadurch aus, dass zumindest für die Photoanregung der Donor-Komponente gilt, dass die gebildeten Exzitonen an der Grenzfläche zum Akzeptor bevorzugt in ein Loch auf dem Donor und ein Elektron auf dem Akzeptor getrennt werden. Als Hauptmaterial wird ein Material bezeichnet, dessen Volumen- oder Massen-Anteil in der Schicht größer als 16% ist. Weitere Materialien können technisch bedingt oder aber zur Einstellung von Schichteigenschaften beigemischt sein. Bereits bei einer Doppelmischschicht enthält das Bauelement drei bzw. vier verschiedene Absorbermaterialien, kann damit einen Spektralbereich von ca. 600nm bzw. ca. 800nm abdecken.

In einer weiteren Ausführung der Erfindung kann die Doppelmischschicht auch dazu benutzt werden, für einen bestimmten Spektralbereich deutlich höhere Photoströme zu erzielen, indem Materialien gemischt werden, die bevorzugt in demselben Spektralbereich absorbieren. Dies kann dann im Weiteren benutzt werden, um in einer Tandemsolarzelle oder Mehrfachsolarzelle eine Stromanpassung zwischen den verschiedenen Teilzellen zu erreichen. Damit ist neben der Verwendung der Kavitätsschicht eine weitere Möglichkeit der Anpassung der Ströme der Teilzellen gegeben.

In einer weiteren Ausführungsform der Erfindung können zur Verbesserung der Ladungsträgertransporteigenschaften der Mischschichten die Mischungsverhältnisse in den verschiedenen Mischschichten gleich oder auch unterschiedlich sein.

In einer weiteren Ausführungsform der Erfindung bestehen die Mischschichten bevorzugt aus jeweils zwei Hauptmaterialien.

In einer weiteren Ausführungsform der Erfindung kann in den einzelnen Mischschichten ein Gradient des Mischungsverhältnisses vorhanden sein.

In einer bevorzugten Ausgestaltung der Erfindung ist das photoaktive Bauelement als Tandemzellen ausgeführt und es besteht durch die Verwendung von Doppel- bzw. Mehrfachmischschichten der weitere Vorteil, dass die Strom-Angleichung (current matching) zwischen den Teilzellen durch die Wahl der Absorbermaterialien in den Mischschichten optimiert und damit der Wirkungsgrad weiter erhöht werden kann.

In einer weiteren Ausführungsform der Erfindung können die einzelnen Materialien dabei in unterschiedlichen Maxima der Lichtverteilung der charakteristischen Wellenlängen, die dieses Material absorbiert, positioniert sein. So kann beispielsweise ein Material in einer Mischschicht im 2. Maximum seiner charakteristischen Wellenlänge liegen und das andere Material im 3. Maximum.

In einer weiteren Ausführungsform der Erfindung besteht das photoaktive Bauelement, insbesondere eine organische Solarzelle, aus einer Elektrode und einer Gegenelektrode und zwischen den Elektroden wenigstens zwei organischen aktiven Mischschichten, wobei die Mischschichten jeweils im Wesentlichen aus zwei Materialien bestehen und die beiden Hauptmaterialien jeweils einer Mischschicht ein Donator-Akzeptor-System bilden sowie die beiden Mischschichten direkt aneinandergrenzen und wenigstens eine der beiden Hauptmaterialien der einen Mischschicht ein anderes organisches Material ist als die beiden Hauptmaterialien einer anderen Mischschicht.

In einer Weiterbildung der vorbeschriebenen Ausführungsform sind mehrere oder alle Hauptmaterialien der Mischschichten voneinander verschieden.

In einer weiteren Ausführungsform der Erfindung handelt es sich um drei oder mehr Mischschichten, welche zwischen der Elektrode und Gegenelektrode angeordnet sind.

In einer weiteren Ausführungsform der Erfindung sind zusätzlich zu den genannten Mischschichten noch weitere photoaktive Einzel- oder Mischschichten vorhanden.

In einer weiteren Ausführungsform der Erfindung ist zwischen dem Mischschichtsystem und der einen Elektrode noch wenigstens eine weitere organische Schicht vorhanden.

In einer weiteren Ausführungsform der Erfindung ist zwischen dem Mischschichtsystem und der Gegenelektrode noch wenigstens eine weitere organische Schicht vorhanden.

In einer weiteren Ausführungsform der Erfindung sind eine oder mehrere der weiteren organischen Schichten dotierte wide-gap Schichten, wobei das Maximum der Absorption bei < 450 nm liegt.

In einer weiteren Ausführungsform der Erfindung weisen mindestens zwei Hauptmaterialien der Mischschichten verschiedene optische Absorptionsspektren auf.

In einer weiteren Ausführungsform der Erfindung weisen die Hauptmaterialien der Mischschichten verschiedene optische Absorptionsspektren auf, die sich gegenseitig ergänzen, um einen möglichst breiten Spektralbereich abzudecken.

In einer weiteren Ausführungsform der Erfindung erstreckt sich der Absorptionsbereich zumindest eines der Hauptmaterialien der Mischschichten in den Infrarot-Bereich.

In einer weiteren Ausführungsform der Erfindung erstreckt sich der Absorptionsbereich zumindest eines der Hauptmaterialien der Mischschichten in den Infrarot-Bereich im Wellenlängenbereich von > 700nm bis 1500nm.

In einer weiteren Ausführungsform der Erfindung sind die HOMO- und LUMO-Niveaus der Hauptmaterialien so angepasst, dass das System eine maximale Leerlaufspannung, einen maximalen Kurzschlussstrom und einen maximalen Füllfaktor ermöglicht.

In einer weiteren Ausführungsform der Erfindung enthält mindestens eine der photoaktiven Mischschichten als Akzeptor ein Material aus der Gruppe der Fullerene bzw. Fullerenderivate (C₆₀, C₇₀, etc.).

In einer weiteren Ausführungsform der Erfindung enthalten alle photoaktiven Mischschichten als Akzeptor ein Material aus der Gruppe der Fullerene bzw. Fullerenderivate (C₆₀, C₇₀, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO2006092134 beschrieben ist.

In einer weiteren Ausführungsform der Erfindung enthält mindestens eine der photoaktiven Mischschichten als Akzeptor das Material Fulleren C₆₀ und als Donator das Material 4P-TPD.

In einer weiteren Ausführungsform der Erfindung bestehen die Kontakte aus Metall, einem leitfähigen Oxid, insbesondere ITO, ZnO:Al oder anderen TCOs oder einem leitfähigen Polymer, insbesondere PEDOT:PSS oder PANI.

Im Sinne der Erfindung sind auch Polymersolarzellen, die zwei oder mehrere photoaktive Mischschichten beinhalten, umfasst, wobei die Mischschichten direkt aneinandergrenzen. Bei Polymersolarzellen besteht aber das Problem das die Materialien aus Lösung aufgebracht werden und somit eine weitere aufgebrachte Schicht sehr leicht dazu führt, dass die darunter liegenden Schichten angelöst, aufgelöst oder in ihrer Morphologie verändert werden. Bei Polymersolarzellen können daher nur sehr eingeschränkt Mehrfachmischschichten hergestellt werden und auch nur dadurch, dass verschiedene Material- und Lösungsmittelsysteme verwendet werden, die sich bei der Herstellung gegenseitig nicht oder kaum beeinflussen. Solarzellen aus kleinen Molekülen haben hier einen ganz klaren Vorteil, da durch den Aufdampfprozess im Vakuum beliebige Systeme und Schichten aufeinander gebracht werden können und somit der Vorteil der Mehrfachmischschichtstruktur sehr breit genutzt und mit beliebigen Materialkombinationen realisiert werden kann.

In einer weitere Ausführungsform des erfindungsgemäßen Bauelementes besteht darin, dass zwischen der ersten elektronenleitenden Schicht (n-Schicht) und der auf dem Substrat befindlichen Elektrode noch eine p-dotierte Schicht vorhanden ist, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der aktiven Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4 eV, bevorzugt aber weniger als 0,3 eV unterhalb des Elektronentransportniveaus der i-Schicht liegt, so dass es zu verlustarmer Elektronenextraktion aus der i-Schicht in diese p-Schicht kommen kann.

In einer weiteren Ausführungsform der Erfindung ist noch ein n-Schichtsystem zwischen der p-dotierten Schicht und der Gegenelektrode vorhanden, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4 eV, bevorzugt aber weniger als 0,3 eV oberhalb des Löchertransportnivaus der i-Schicht liegt, so dass es zu verlustarmer Löcherextraktion aus der i-Schicht in diese n-Schicht kommen kann.

Eine weitere Ausführungsform des erfindungsgemäßen Bauelementes besteht darin, dass das Bauelement ein n-Schichtsystem und/oder ein p-Schichtsystem enthält, so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer weiteren Ausführungsform der Erfindung werden mehrere Konversionskontakte hintereinandergeschaltet, so dass es sich z.B. um eine npnipn, pnipnp, npnipnp, pnpnipnpn oder pnpnpnipnpnpn Struktur handelt.

In einer bevorzugten Weiterbildung der oben beschriebenen Strukturen sind diese als organische Tandemsolarzelle oder Mehrfachsolarzelle ausgeführt. So kann es sich bei dem Bauelement um eine Tandemzelle aus einer Kombination aus nip, ni, ip, pnip, pni, pip, nipn, nin, ipn, pnipn, pnin oder pipn-Strukturen handeln, bei der mehrere unabhängige Kombinationen, die mindestens eine i-Schicht enthalten, übereinander gestapelt sind (Kreuzkombinationen).

In einer weiteren Ausführungsform der oben beschriebenen Strukturen ist diese als eine pnipnipn-Tandemzelle ausgeführt.

In einer weiteren Ausführungsform liegt das Akzeptor-Material in der Mischschicht zumindest teilweise in kristalliner Form vor.

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor.

In einer weiteren Ausführungsform verfügt das Akzeptor-Material über ein Absorptionsmaximum im Wellenlängenbereich > 450 nm.

In einer weiteren Ausführungsform verfügt das Donator-Material über ein Absorptionsmaximum im Wellenlängenbereich > 450 nm.

In einer weiteren Ausführungsform enthält das aktive Schichtsystem zusätzlich zu der genannten Mischschicht noch weitere photoaktive Einzel- oder Mischschichten.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform enthält das n-Materialsystem eine oder mehrere dotierte wide-gap Schichten. Der Begriff wide-gap Schichten definiert dabei Schichten mit einem Absorptionsmaximum im Wellenlängenbereich < 450 nm.

In einer weiteren Ausführungsform enthält das p-Materialsystem eine oder mehrere dotierte wide-gap Schichten.

In einer weiteren Ausführungsform enthält das Bauelement zwischen der ersten elektronenleitenden Schicht (n-Schicht) und der auf dem Substrat befindlichen Elektrode eine p-dotierte Schicht, so dass es sich um eine pnip oder pni-Struktur handelt.

In einer weiteren Ausführungsform enthält das Bauelement zwischen der photoaktiven i-Schicht und der auf dem Substrat befindlichen Elektrode eine p-dotierte Schicht, so dass es sich um eine pip oder pi-Struktur handelt, wobei die zusätzliche p-dotierte Schicht eine Ferminiveaulage hat, die höchstens 0,4 eV, bevorzugt aber weniger als 0,3 eV unterhalb des Elektronentransportnivaus der i-Schicht liegt.

In einer weiteren Ausführungsform enthält das Bauelement ein n-Schichtsystem zwischen der p-dotierten Schicht und der Gegenelektrode, so dass es sich um eine nipn oder ipn-Struktur handelt.

In einer weiteren Ausführungsform enthält das Bauelement ein n-Schichtsystem zwischen der photoaktiven i-Schicht und der Gegenelektrode, so dass es sich um eine nin- oder in-Struktur handelt, wobei die zusätzliche n-dotierte Schicht eine Ferminiveaulage hat, die höchstens 0,4 eV, bevorzugt aber weniger als 0,3 eV oberhalb des Löchertransportniveaus der i-Schicht liegt.

In einer weiteren Ausführungsform enthält das Bauelement ein n-Schichtsystem und/oder ein p-Schichtsystem, so dass es sich um eine pnipn, pnin, pipn- oder p-i-n-Struktur handelt.

In einer weiteren Ausführungsform enthält das zusätzliche p-Materialsystem und/oder das zusätzliche n-Materialsystem eine oder mehrere dotierte wide-gap Schichten.

In einer weiteren Ausführungsform enthält das Bauelement noch weitere n-Schichtsysteme und/oder p-Schichtsysteme, so dass es sich z.B. um eine npnipn, pnipnp, npnipnp, pnpnipnpn oder pnpnpnipnpnpn -Struktur handelt.

In einer weiteren Ausführungsform enthält eines oder mehrere der weiteren p-Materialsysteme und/oder der weiteren n-Materialsysteme eine oder mehrere dotierte wide-gap Schichten.

In einer weiteren Ausführungsform handelt es sich bei dem Bauelement um eine Tandemzelle aus einer Kombination aus nip, ni, ip, pnip, pni, pip, nipn, nin, ipn, pnipn, pnin oder pipn-Strukturen.

In einer weiteren Ausführungsform handelt es sich bei den organischen Materialien zumindest teilweise um Polymere, wobei aber zumindest eine photoaktive i-Schicht aus kleinen Molekülen gebildet ist.

In einer weiteren Ausführungsform ist das Akzeptor-Material ein Material aus der Gruppe der Fullerene bzw. Fullerenderivate (bevorzugt C₆₀ oder C₇₀) oder ein PTCDI-Derivat (Perylen-3, 4, 9, 10-bis(dicarboximid)-Derivat).

In einer weiteren Ausführungsform ist das Donator-Material ein Oligomer, insbesondere ein Oligomer nach WO2006092134, ein Porphyrin-Derivat, ein Pentacen-Derivat oder ein Perylenderivat, wie DIP (Di-Indeno-Perylen), DBP (Di-benzoperylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-di(1-naphthyl)-N,N'-diphenyl-(1,1'-biphenyl) 4,4'-diamine), MTDATA (4,4',4"-Tris-(N-3-methylphenyl-N-phenyl-amino)-triphenylamin), TNATA (4,4',4"-Tris[N-(1-naphthyl)-N-phenyl-amino]-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-l-yl-phenyl-N,N-di 4-methylphenylphenylbenzidine), 4P-TPD (4,4'-bis-(N,N-diphenylamino)-tetraphenyl), oder ein in DE102004014046 beschriebenes p-Material.

In einer weiteren Ausführungsform enthält das n-Materialsystem Fullerene, wie beispielsweise C₆₀, C₇₀; NTCDA (1, 4, 5, 8-Naphthalene-tetracarboxylic-dianhydride), NTCDI (Naphthalenetetracarboxylic diimide) oder PTCDI (Perylen-3, 4, 9, 10-bis (dicarboximid).

In einer weiteren Ausführungsform enthält das p-Materialsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Materialsystem einen n-Dotanden, wobei dieser n-Dotand ein TTF-Derivat (Tetrathiafulvalen-Derivat) oder DTT-Derivat (dithienothiophen), ein n-Dotand wie in DE10338406, DE10347856, DE10357044, DE102004010954, DE102006053320, DE102006054524 und DE102008051737 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform weisen die verwendeten organischen Materialien einen niedrigem Schmelzpunkt, bevorzugt < 100°C, auf.

In einer weiteren Ausführungsform weisen die verwendeten organischen Materialien eine niedrige Glasübergangstemperatur, bevorzugt < 150°C, auf.

In einer weiteren Ausführungsform der Erfindung wird durch Verwendung von Lichtfallen der optische Weg des einfallenden Lichtes im aktiven System vergrößert.

In einer weiteren Ausführungsform der Erfindung ist das Bauelement als organische pin-Solarzelle bzw. organische pin-Tandemsolarzelle ausgeführt. Als Tandemsolarzelle wird dabei eine Solarzelle bezeichnet, die aus einem vertikalen Stapel zweier in Serie verschalteter Solarzellen besteht.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform der Erfindung wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise dadurch erreichen, dass das Substrat pyramidenartige Strukturen auf der Oberfläche aufweist mit Höhen und Breiten jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein.

In einer weiteren Ausführungsform der Erfindung wird die Lichtfalle dadurch realisiert, dass eine dotierte wide-gap-Schicht eine glatte Grenzfläche zur i-Schicht und eine raue Grenzfläche zum reflektierenden Kontakt hat. Die raue Grenzfläche kann beispielsweise durch eine periodische Mikrostrukturierung erreicht werden. Besonders vorteilhaft ist die raue Grenzfläche, wenn sie das Licht diffus reflektiert, was zu einer Verlängerung des Lichtweges innerhalb der photoaktiven Schicht führt.

In einer weiteren Ausführungsform wird die Lichtfalle dadurch realisiert, dass das Bauelement auf einem periodisch mikrostrukturierten Substrat aufgebaut wird und eine dotierte wide-gap-Schicht eine glatte Grenzfläche zur i-Schicht und eine raue Grenzfläche zum reflektierenden Kontakt hat.

In einer weiteren Ausführungsform der Erfindung ist die Gesamtstruktur des optoelektronischen Bauelements mit transparentem Grund- und Deckkontakt versehen.

In einer weiteren Ausführungsform der Erfindung werden die erfindungsgemäßen photoaktiven Bauelemente zur Anordnung auf Formkörpern, wie etwa Glas, Beton, Kunststoffen und Gewächshäusern verwendet.

Zur Realisierung der Erfindung können auch die vorbeschriebenen Ausführungsformen miteinander kombiniert werden.

Nachfolgend soll die Erfindung anhand einiger Ausführungsbeispiele und Figuren eingehend erläutert werden. Die Ausführungsbeispiele sollen dabei die Erfindung beschreiben ohne diese zu beschränken. Es zeigen in
Fig. 1 eine schematische Darstellung eines erfindungsgemäßen photoaktiven Bauelements, in
Fig. 2 eine weitere schematische Darstellung eines erfindungsgemäßen photoaktiven Bauelements, in
Fig. 3 eine weitere schematische Darstellung eines erfindungsgemäßen photoaktiven Bauelements, in
Fig. 4 eine weitere schematische Darstellung eines erfindungsgemäßen photoaktiven Bauelements mit IR-Filter und in
Fig. 5 eine weitere schematische Darstellung eines erfindungsgemäßen photoaktiven Bauelements mit IR- und UV-Filter.

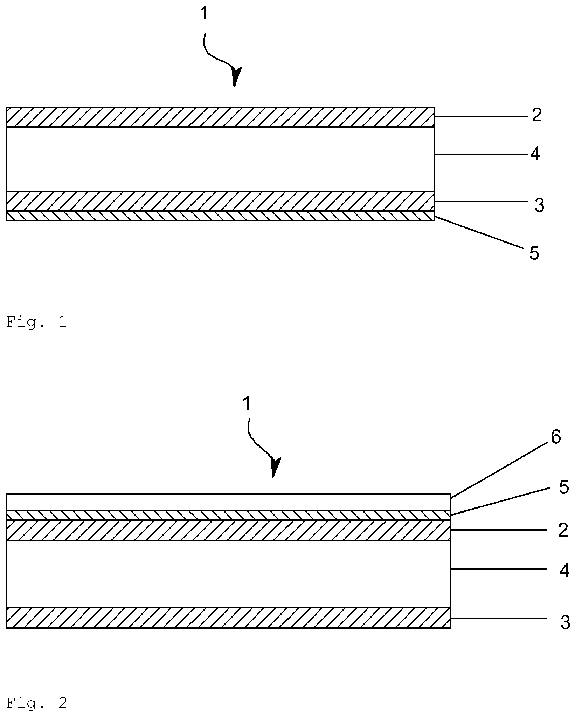

In einem ersten Ausführungsbeispiel ist in Fig. 1 ein erfindungsgemäßes photoaktives Bauelement 1, welches beispielsweise als organische Solarzelle ausgeführt ist, dargestellt. Diese umfasst eine erste Elektrode 2, welche beispielsweise als transparente DMD-Elektrode (Dielektrikum-Metall-Dielektrikum) ausgeführt ist und eine zweite Elektrode 3, welche beispielsweise aus einem transparent leitfähigen Oxid, wie etwa ITO, ausgeführt ist. Zwischen diesen beiden Elektroden 2,3 ist ein photoaktives Schichtsystem 4 angeordnet. Dieses photoaktive Schichtsystem 4 kann beispielsweise ein Donor-Akzeptor-System aus kleinen organischen Molekülen umfassen. Auf der der Lichteinstrahlung gegenüberliegenden Seite des photoaktiven Bauelements 1 ist die als spektral selektiver Farbfilter in zumindest einem Bereich von 450 nm bis 800 nm ausgestaltete erste Schicht 5 angeordnet. Diese umfasst beispielsweise ein organisches absorbierendes Material. Das nicht näher dargestellte Substrat kann dabei sowohl auf der lichteinfallenden Seite bei der ersten Elektrode 2 angeordnet sein als auch auf der gegenüberliegenden Seite bei der zweiten Elektrode 3 angeordnet sein.

In einem weiteren Ausführungsbeispiel ist in Fig. 2 eine alternative Ausgestaltung des vorbeschriebenen Ausführungsbeispiels wiedergegeben. Dabei ist die als spektral selektiver Farbfilter im Bereich von 450 nm bis 800 nm ausgestaltete erste Schicht 5 auf der lichteinfallenden Seite angeordnet. Zudem umfasst das Bauelement eine Einkopplungsschicht 6, welche als Antireflexschicht oder Kratzschutzschicht fungiert und eine Propagierung des Lichts in das Bauelement unterstützt. Dabei können sowohl die erste Schicht 5 als auch die Schicht 6 in beliebiger Reihenfolge als auch in Mischung angeordnet sein. Auch in dieser Ausgestaltung kann das nicht näher dargestellte Substrat sowohl auf der lichteinfallenden Seite bei der ersten Elektrode 2 angeordnet sein als auch auf der gegenüberliegenden Seite bei der zweiten Elektrode 3 angeordnet sein.

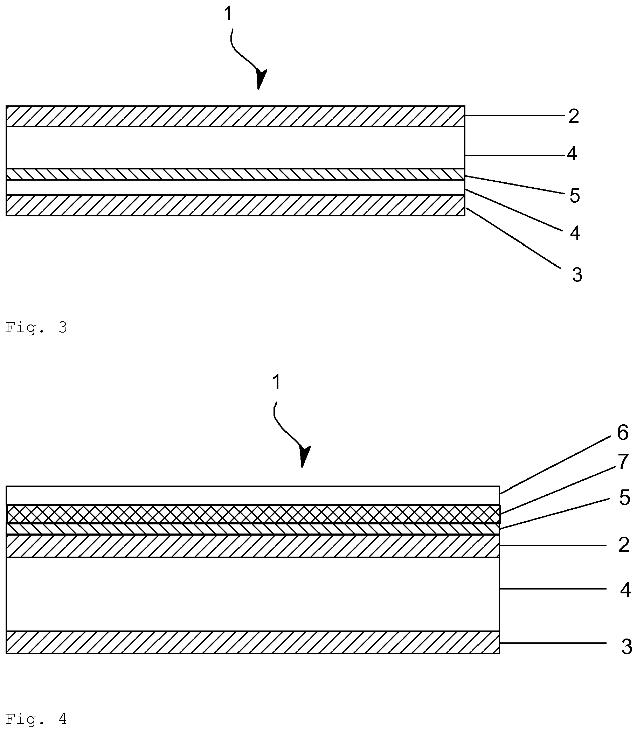

In einem weiteren Ausführungsbeispiel ist in Fig. 3 ein weiteres erfindungsgemäßes Bauelement dargestellt. Dabei ist die erste Schicht 5 als eine Ladungsträgertransportschicht, welche eine Absorption in zumindest einem Teilbereich des Wellenlängenbereichs im Bereich von 450 nm bis 800 nm aufweist, ausgebildet. Die erste Schicht 5- in diesem Fall als Ladungsträgertansportschicht ausgeführt - kann dabei als Lochleiter oder Elektronentransportschicht ausgeführt sein, wobei die erste Schicht 5, hier Ladungsträgertransportschicht, eine Absorption aufweist, die nicht zur Ladungsträgergeneration beiträgt. Die erste Schicht 5 kann dabei beispielsweise aus MPP oder n-C₆₀ ausgeführt sein. Beispielsweise kann die Ladungsträgertransportschicht zwischen zwei photoaktiven Schichtsystemen 4 einer Tandemzelle angeordnet sein.

In einem weiteren Ausführungsbeispiel ist in Fig. 4 eine alternative Ausgestaltung des vorbeschriebenen Ausführungsbeispiele wiedergegeben. Dabei ist die als spektral selektiver Farbfilter im Bereich von 450 nm bis 800 nm ausgestaltete erste Schicht 5 auf der lichteinfallenden Seite angeordnet. Zudem umfasst das Bauelement eine Einkopplungsschicht 6, welche als Antireflexschicht oder Kratzschutzschicht fungiert und eine Propagierung des Lichts in das Bauelement unterstützt. Dabei können sowohl die erste Schicht 5 als auch die Schicht 6 in beliebiger Reihenfolge als auch in Mischung angeordnet sein. Auch in dieser Ausgestaltung kann das nicht näher dargestellte Substrat sowohl auf der lichteinfallenden Seite bei der ersten Elektrode 2 angeordnet sein als auch auf der gegenüberliegenden Seite bei der zweiten Elektrode 3 angeordnet sein. Weiterhin umfasst das photoaktive Bauelement 1 eine zweite Schicht oder Schichtfolge 7, welche als IR-Filter in zumindest einem Bereich von 850 nm bis 2500 nm wirkt. Dadurch wird ein Wärmeeintrag beispielsweise in Gebäude vermindert.

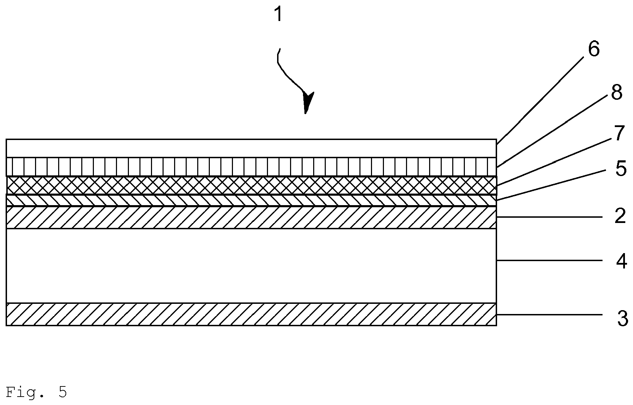

In einem weiteren Ausführungsbeispiel ist in Fig. 5 eine alternative Ausgestaltung des vorbeschriebenen Ausführungsbeispiele wiedergegeben. Dabei umfasst das photoaktive Bauelement 1 eine dritte Schicht oder Schichtfolge 8, welche als UV-Filter in zumindest einem Bereich von 250 nm bis 430 nm wirkt. Die als UV-Filter fungierende Schicht dient dabei dem Schutz der organischen Moleküle, welche beispielsweise in der photoaktiven Schicht enthalten sind.

### Bezugszeichenliste

1 photoaktives Bauelement
2 Elektrode
3 Elektrode
4 photoaktives Schichtsystem
5 erste Schicht oder Schichtfolge, auch als Filterschicht bezeichnet
6 Einkopplungsschicht
7 zweite Schicht oder Schichtfolge, auch als IR-Filterschicht bezeichnet
8 dritte Schicht oder Schichtfolge, auch als UV-Filterschicht bezeichnet

## Patentansprüche

1. Photoaktives Bauelement (1) auf einem Substrat umfassend eine erste und eine zweite Elektrode (2,3), wobei die erste Elektrode auf dem Substrat angeordnet ist und die zweite Elektrode eine Gegenelektrode bildet, wobei zwischen diesen Elektroden (2,3) zumindest ein photoaktives Schichtsystem (4) angeordnet ist, **dadurch gekennzeichnet, dass** das photoaktive Bauelement (1) weiterhin zumindest eine erste Schicht oder Schichtfolge (5) und weiterhin zumindest eine zweite Schicht oder Schichtfolge (7) aufweist, die so ausgestaltet sind, dass in dem photoaktiven Bauelement (1) die erste Schicht oder Schichtfolge (5) als spektral selektiver Farbfilter in zumindest einem Bereich von 450 nm bis 800 nm wirkt und die zweite Schicht oder Schichtfolge (7) in dem photoaktiven Bauelement (1) als spektral selektiver IR-Filter in zumindest einem Bereich von 850 nm bis 2500 nm wirkt.

2. Bauelement nach Anspruch 1, **dadurch gekennzeichnet, dass** das Bauelement (1) weiterhin zumindest eine dritte Schicht oder Schichtfolge (8) aufweist, welche so ausgestaltet ist, dass diese in dem photoaktiven Bauelement (1) als spektral selektiver UV-Filter in zumindest einem Bereich des UV-Bereichs von 250 nm bis 430 nm wirkt.

3. Bauelement nach einem der vorhergehenden Ansprüche, **dadurch gekennzeichnet, dass** die als Farbfilter wirkende erste Schicht oder Schichtfolge (5) oder zweite Schicht oder Schichtfolge (7) oder dritte Schicht oder Schichtfolge (8) zumindest ein absorbierendes Material umfasst, wobei die Schicht oder Schichtfolge so ausgestaltet ist, dass diese keine elektrische Kontaktierung aufweist.

4. Bauelement nach einem der vorhergehenden Ansprüche, **dadurch gekennzeichnet, dass** die erste Schicht oder Schichtfolge (5) oder zweite Schicht oder Schichtfolge (7) oder dritte Schicht oder Schichtfolge (8) außerhalb der Elektroden (2, 3) angeordnet ist.

5. Bauelement nach einem der vorhergehenden Ansprüche, **dadurch gekennzeichnet, dass** die erste Schicht oder Schichtfolge (5) oder zweite Schicht oder Schichtfolge (7) oder dritte Schicht oder Schichtfolge (8) organische und/oder anorganische Stoffe oder einer Kombination davon umfasst.

6. Bauelement nach einem der vorhergehenden Ansprüche, **dadurch gekennzeichnet, dass** die erste (5) Schicht oder Schichtfolge oder zweite Schicht oder Schichtfolge (7) oder dritte Schicht oder Schichtfolge (8) Nanomaterialien aufweist, welche als farblich selektiv absorbierende Schicht ausgebildet sind, umfasst.

7. Bauelement nach einem der vorhergehenden Ansprüche, **dadurch gekennzeichnet, dass** die erste Schicht oder Schichtfolge (5) oder Schicht oder Schichtfolge zweite (7) oder dritte Schicht oder Schichtfolge (8) zumindest einen Fluoreszenzfarbstoff umfasst.

8. Bauelement nach einem der vorhergehenden Ansprüche, **dadurch gekennzeichnet, dass** die erste Schicht oder Schichtfolge (5) oder zweite Schicht oder Schichtfolge (7) oder dritte Schicht oder Schichtfolge (8) entweder auf der der Lichteinstrahlung zugewandten oder auf der der Lichteinstrahlung abgewandten Seite des Bauelements (1) angeordnet ist.

9. Bauelement nach einem der vorhergehenden Ansprüche, **dadurch gekennzeichnet, dass** die erste Schicht oder Schichtfolge (5) oder zweite Schicht oder Schichtfolge (7) oder dritte Schicht oder Schichtfolge (8) auf der lichtzugewandten Seite des photoaktiven Bauelements als metallische Struktur ausgeführt ist.

10. Bauelement nach einem der vorhergehenden Ansprüche, **dadurch gekennzeichnet, dass** die erste Schicht oder Schichtfolge (5) eine Schichtdicke von zumindest 3 nm bis 100 µm, bevorzugt zwischen 5 nm und 300 nm aufweist.

11. Bauelement nach einem der vorhergehenden Ansprüche, **dadurch gekennzeichnet, dass** das Substrat transparent oder opak ist.

12. Bauelement nach einem der vorhergehenden Ansprüche, **dadurch gekennzeichnet, dass** das Substrat als Glas oder Folie ausgeführt ist.

13. Bauelement nach einem der vorhergehenden Ansprüche, **dadurch gekennzeichnet, dass** das photoaktive Bauelement (1) eine organische Solarzelle ist, wobei bevorzugt die photoaktive Schicht kleine, organische Moleküle aufweist.

14. Bauelement nach einem der vorhergehenden Ansprüche, **dadurch gekennzeichnet, dass** mindestens eine der Transportschichten mindestens ein Material aufweist, das als farblich selektiver Filter verwendet werden kann.

15. Verwendung eines photoaktiven Bauelements (1) nach einem der Ansprüche 1 bis 14 zur Anordnung auf Formkörpern.

## Claims

1. A photoactive component (1) on a substrate comprising a first and a second electrode (2, 3) wherein the first electrode is arranged on the substrate and the second electrode forms a counterelectrode, wherein at least one photoactive layer system (4) is arranged between said electrodes (2, 3), **characterized in that** the photoactive component furthermore comprises at least one first layer or layer sequence (5) and furthermore comprises at least one second layer or layer sequence (7) configured such that the first layer or layer sequence (5) acts as a spectrally selective color filter in at least one range from 450 nm to 800 nm and the second layer or layer sequence (7) acts as a spectrally selective IR filter in at least one range from 850 nm to 2500 nm in the photoactive component.

2. The component according to claim 1, **characterized in that** the component (1) furthermore comprising at least one third layer or layer sequence (8) configured such that the latter acts as a spectrally selective UV filter in at least one range of the UV range from 250 nm to 430 nm in the photoactive component (1).

3. The component according to any of the preceding claims, **characterized in that** the first layer or layer sequence (5) acting as a color filter, or the second layer or layer sequence (7) acting as a color filter, or the third layer or layer sequence (8) acting as a color filter comprise at least one absorbent material, wherein the layer is configured such that it has no electrical contact-connection.

4. The component according to any of the preceding claims, **characterized in that** the first layer or layer sequence (5), or the second layer or layer sequence (7), or the third layer or layer sequence (8) is arranged outside the electrodes (2, 3).

5. The component according to any of the preceding claims, **characterized in that** the first layer or layer sequence (5), or the second layer or layer sequence (7), or the third layer or layer sequence (8) comprises organic and/or inorganic substances or a combination thereof.

6. The component according to any of the preceding claims, **characterized in that** the first layer or layer sequence (5), or the second layer or layer sequence (7), or the third layer or layer sequence (8) comprises nanomaterials embodied as a color-selectively absorbent layer.

7. The component according to any of the preceding claims, **characterized in that** the first layer or layer sequence (5), or the second layer or layer sequence (7), or the third layer or layer sequence (8) comprises at least one fluorescent dye.

8. The component according to any of the preceding claims, **characterized in that** the first layer or layer sequence (5), or the second layer or layer sequence (7), or the third layer or layer sequence (8) is arranged either on the side of the photoactive component (1) facing the light incidence or on the side of the photoactive component (1) facing away from the light incidence.

9. The component according to any of the preceding claims, **characterized in that** the first layer or layer sequence (5), or the second layer or layer sequence (7), or the third layer or layer sequence (8) on the light-facing side of the photoactive component is embodied as a metallic structure.

10. The component according to any of the preceding claims, **characterized in that** the layer or layer sequence (5) has a layer thickness of at least 3 nm to 100 µm, preferably between 5 nm and 300 nm.

11. The component according to any of the preceding claims, **characterized in that** the substrate is transparent or opaque.

12. The component according to any of the preceding claims, **characterized in that** the substrate is embodied as glass or film.

13. The component according to any of the preceding claims, **characterized in that** the photoactive component (1) is an organic solar cell, wherein the photoactive layer preferably comprising small organic molecules.

14. The component according to any of the preceding claims, **characterized in that** at least one transport layer comprising at least one material usable as a selective color filter.

15. The use of a photoactive component according to any of claims 1 to 14 for arrangement on shaped bodies.

## Revendications

1. Composant photo-actif (1) prévu sur un substrat et comprenant une première et une deuxième électrode (2, 3),
la première électrode étant disposée sur le substrat et la deuxième électrode formant une contre-électrode,
au moins un système (4) de couches photo-actives étant disposé entre ces électrodes (2, 3),
**caractérisé en ce que**
le composant photo-actif (1) présente en outre au moins une première couche ou succession (5) de couches et en outre au moins une deuxième couche ou succession (7) de couches configurées de telle sorte que dans le composant photo-actif (1), la première couche ou succession de couches (5) agissent comme filtre coloré à sélectivité spectrale dans au moins une plage de 450 nm à 800 nm et que la deuxième couche ou succession de couches (7) agissent dans le composant photo-actif (1) comme filtre IR à sélectivité spectrale dans au moins une plage de 850 nm à 2500 nm.

2. Composant selon la revendication 1, **caractérisé en ce que** le composant (1) présente en outre une troisième couche ou succession (8) de couches configurées de telle sorte qu'elles agissent dans le composant photo-actif (1) comme filtre UV à sélectivité spectrale dans au moins une partie de 250 nm à 430 nm de la plage UV.

3. Composant selon l'une des revendications précédentes, **caractérisé en ce que** la première couche ou succession (5) de couches, la deuxième couche ou succession (7) de couches ou la troisième couche ou succession (8) de couches agissant comme filtres colorés comprennent au moins un matériau absorbant, les couches ou successions de couches étant configurées de telle sorte qu'elles ne présentent pas de contact électrique.

4. Composant selon l'une des revendications précédentes, **caractérisé en ce que** la première couche ou succession (5) de couches, la deuxième couche ou succession (7) de couches ou la troisième couche ou succession (8) de couches sont situées à l'extérieur des électrodes (2, 3).

5. Composant selon l'une des revendications précédentes, **caractérisé en ce que** la première couche ou succession (5) de couches, la deuxième couche ou succession (7) de couches ou la troisième couche ou succession (8) de couches comprennent des substances organiques et/ou inorganiques ou une de leurs combinaisons.

6. Composant selon l'une des revendications précédentes, **caractérisé en ce que** la première couche ou succession (5) de couches, la deuxième couche ou succession (7) de couches ou la troisième couche ou succession (8) de couches présentent des nanomatériaux configurés comme couches absorbantes à sélectivité chromatique.

7. Composant selon l'une des revendications précédentes, **caractérisé en ce que** la première couche ou succession (5) de couches, la deuxième couche ou succession (7) de couches ou la troisième couche ou succession (8) de couches comprennent au moins un colorant à fluorescence.

8. Composant selon l'une des revendications précédentes, **caractérisé en ce que** la première couche ou succession (5) de couches, la deuxième couche ou succession (7) de couches ou la troisième couche ou succession (8) de couches sont disposées soit sur le côté du composant (1) tourné vers la lumière incidente ou sur son côté non tourné vers la lumière incidente.

9. Composant selon l'une des revendications précédentes, **caractérisé en ce que** la première couche ou succession (5) de couches, la deuxième couche ou succession (7) de couches ou la troisième couche ou succession (8) de couches sont réalisées sous la forme d'une structure métallique prévue sur le côté du composant photo-actif tourné vers la lumière.

10. Composant selon l'une des revendications précédentes, **caractérisé en ce que** la première couche ou succession (5) de couches présente une épaisseur d'au moins 3 nm à 100 µm et de préférence comprise entre 5 nm et 300 nm.

11. Composant selon l'une des revendications précédentes, **caractérisé en ce que** le substrat est transparent ou opaque.

12. Composant selon l'une des revendications précédentes, **caractérisé en ce que** le substrat est configuré sous la forme de verre ou d'un film.

13. Composant selon l'une des revendications précédentes, **caractérisé en ce que** le composant photo-actif (1) est une cellule solaire organique, la couche photo-active présentant de préférence de petites molécules organiques.

14. Composant selon l'une des revendications précédentes, **caractérisé en ce qu'**au moins l'une des couches de transport présente au moins un matériau qui peut être utilisé comme filtre à sélectivité chromatique.

15. Utilisation d'un composant photo-actif (1) selon l'une des revendications 1 à 14 en vue d'un agencement sur des corps moulés.
